# EUROPEAN PATENT SPECIFICATION

(11) **EP 0 486 986 B1**
(45) Date of publication and mention of the grant of the patent: **04.06.1997**
(21) Application number: 91119631.9
(22) Date of filing: 18.11.1991
(51) Int. Cl.: H03F 3/343, H03F 3/30, H03F 1/30

(54) **Buffer circuit**
Pufferschaltung
Circuit tampon

(30) Priority: 19.11.1990 JP 311277/90
(43) Date of publication of application: 27.05.1992
(73) Proprietor: CANON KABUSHIKI KAISHA, Tokyo (JP)
(72) Inventor: Sakurai, Katsuhito, c/o Canon Kabushiki Kaisha, Ohta-ku, Tokyo 146 (JP)
(74) Representative: Pellmann, Hans-Bernd, Dipl.-Ing.

(56) References cited:
- INTERNATIONAL JOURNAL OF ELECTRONICS. vol. 59, no. 6, December 1985, LONDON GB pages 771 - 777; G. NORMAND: 'Translinear current conveyors'
- INTERNATIONAL JOURNAL OF ELECTRONICS. vol. 57, no. 5, November 1984, LONDON GB pages 713 - 717; A. FABRE: 'An integrable multiple output translinear current convertor'
- ELECTRONIC DESIGN. vol. 35, no. 5, 5 March 1987, HASBROUCK HEIGHTS, NEW JERSEY pages 71 - 74; F. GOODENOUGH: 'Electronic Design
- Report ISSCC: ANALOG'

## Description

### BACKGROUND OF THE INVENTION

### Field of the Invention

This invention relates to a buffer circuit for use in, for example, impedance conversion, an input unit for current feedback type operational amplifiers and the like.

### Related Background Art

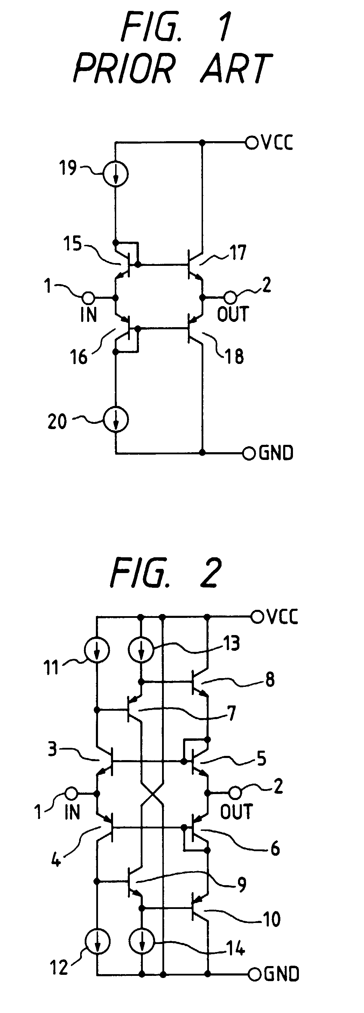

Heretofore, the buffer circuit is composed of diode-connected transistors 15 and 16 which are opposite to each other in polarity, transistors 17 and 18 matching those transistors 15 and 16 respectively, and constant-current sources 19 and 20 for feeding constant current to the transistors 15 and 16 as shown in Fig. 1.

In the above conventional example, however, the transistors 15 and 17, and the transistors 16 and 18, for which matching is required respectively, are operated by a different C-E (Collector-Emitter) voltage. Therefore, an offset appears between input (IN) and output (OUT) due to the Early's effect of transistors, possibly causing a malfunction.

The article "An integrable multiple output translinear current converter" by A. Fabre disclosed on pages 713 to 717 of the INTERNATIONAL JOURNAL OF ELECTRONICS, Vol. 57, No. 5, November 1984 relates to a current converter circuit comprising a plurality of output stages and an input stage having a level shift circuit provided in order to impose a zero collector-base voltage of the transistors of the input stage. Thus, a proper current conversion from the input stage to the output stages can be achieved.

However, such a circuit configuration has a low dynamic input resistance and a high dynamic output resistance and is therefore not suitable for a buffer circuit.

Furthermore, Fabre does not suggest how to remove an offset voltage between an input and an output terminal of the input and the output stage, respectively.

It is therefore an object of the present invention to provide a buffer circuit which is capable of preventing an offset voltage between an input and an output terminal.

This object is achieved by a buffer circuit according to claim 1.

Accordingly, by providing the claimed level shift circuits of an emitter follower type the offset voltage between the input and the output terminal of the buffer circuit is forced to zero.

### BRIEF DESCRIPTION OF THE DRAWINGS

Fig. 1 is a circuit diagram of a buffer circuit according to a conventional example;
Fig. 2 is a circuit diagram of a buffer circuit embodying the concept of the present invention; and
Fig. 3 is a circuit diagram of an input buffer for current feedback type operational amplifiers embodying the concept of the present invention.

### DESCRIPTION OF THE PREFERRED EMBODIMENTS

The present invention will hereinafter be described in detail with respect to embodiments thereof shown in the drawings.

### (First Embodiment)

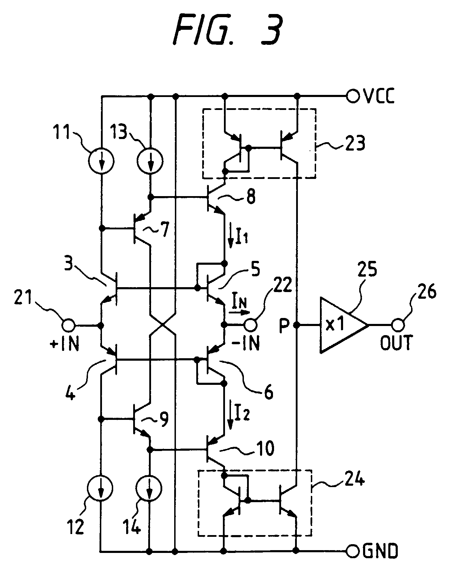

A preferred embodiment of the present invention is best shown in Fig. 2. In Fig. 2, numeral 1 is an input terminal, and numeral 2 is an output terminal. Transistors 3 and 4, which are opposite to each other in polarity, are connected with the input terminal 1, and are biased by constant-current sources 11 and 12 respectively. Transistors 5 and 6 are connected with the output terminal 2, and are diode-connected with a short between the base and the collector, requiring matching with those transistors 3 and 4 respectively. Transistors 7 and 8, and transistors 9 and 10 are used to keep constant the C-E voltage of the transistors 3 and 4, and the transistors 7 and 9 are biased by constant-current sources 13 and 14 respectively.

When an input voltage is applied to the input terminal 1, a voltage of the same value is output at the output terminal 2. At this time, the C-B (collector-base) voltage of the transistor 3 is kept down at 0 (V) by means of Vbe of the transistors 7 and 8, and the C-E voltage of the transistor 3 is kept down at 1 x Vbe (V).

Similarly, the C-B voltage of the transistor 4 is kept down at 0 (V) by means of Vbe of the transistors 9 and 10, and the C-E voltage of the transistor 4 at 1 x Vbe (V). Since the transistors 3 and 5, and the transistors 4 and 6 are operating at the same C-E voltage 1 x Vbe (V), there is no difference in operating current between the two due to the Early's effect, but an offset between the input and output terminals is very small. The circuit described above is integrated on a semiconductor substrate for formation.

### (Second Embodiment)

Fig. 3 shows an example in which the above embodiment has been used as an input buffer for a current feedback type operational amplifier. In Fig. 3, numeral 21 is a forward input terminal, numeral 22 is a reverse input terminal, numerals 23 and 24 are current mirror circuits, numeral 25 is an output buffer, and numeral 26 is an output terminal.

An input current IN flows through the reverse input terminal 22 by an input voltage applied to between the forward and reverse input terminals, and becomes a differential current between a current I₁ above and a current I₂ below the reverse input terminal 22. This differential current flows to the output stage through current mirror circuits 23 and 24, is converted into a voltage at a point P, and is output at the output terminal 26 through an output buffer 25.

An offset between forward 21 and reverse 22 input terminals at this time is increased by the gain times and becomes an offset at the output terminal 26. When a buffer circuit according to the present invention is used as an input buffer, the offset between the forward 21 and reverse 22 input terminals becomes very small, and as a result, the offset at the output terminal 26 is also reduced. This operational amplifier consists of a semiconductor integrated circuit.

According to the present invention as described above, an offset between an input and output can be reduced by keeping down at a very small value a C-E voltage difference between transistors for which matching is required to each other for operation.

## Claims

1. A buffer circuit comprising:
a) an input stage having a first transistor (**3**) of a first conductivity type and a second transistor (**4**) of a second conductivity type different from the first conductivity type, each having a base, a collector and an emitter, and said input stage having an input terminal (**1**) connected to the emitters of said first and second transistors;
b) an output stage having a third transistor (**5**) of the first conductivity type and a second transistor (**6**) of the second conductivity type, each having a base, a collector and an emitter, and a terminal **(2)** connected to the emitters of said third and fourth transistors;
c) first connecting means for connecting the base of said first transistor **(3)** with the base and the collector of said third transistor **(5)**,
d) second connecting means for connecting the base of said second transistor (**4**) with the base and the collector of said fourth transistor (**6**),
e) a first emitter follower level shift circuit for connecting the collector of said first transistor (**3**) with the collector of said third transistor (**5**), having a fifth transistor (**8**) of said first conductivity type and a sixth transistor **(7)** of said second conductivity type; and
f) a second emitter follower level shift circuit for connecting the collector of said second transistor (**4**) with the collector of said fourth transistor **(6)**, having a seventh transistor **(9)** of said first conductivity type and an eighth transistor **(10)** of said second conductivity type,
g) wherein said sixth (**7**) and said seventh (**9**) transistor have their bases connected to the collectors of said first (**3**) and said second (**4**) transistor, respectively, the emitters of said fifth (**8**) and said eighth (**10**) transistor are connected to the collectors of said third (**5**) and said fourth (**6**) transistor, respectively, and the bases of said fifth (**8**) and said eighth (**10**) transistor are connected to the emitters of said sixth (**7**) and said seventh (**9**) transistor, respectively, such that the collector-base voltages of said first (**3**) and said second (**4**) transistor are kept substantially zero.

2. A buffer circuit according to claim 1, wherein said buffer circuit constitutes a semiconductor integrated circuit.

3. A current feedback type operational amplifier comprising an input unit provided with a buffer circuit according to claim 1.

## Patentansprüche

1. Pufferschaltung, mit
a) einer Eingangsstufe mit einem ersten Transistor (3) eines ersten Leitfähigkeitstyps und einem zweiten Transistor (4) eines zweiten Leitfähigkeitstyps, der von dem ersten Leitfähigkeitstyp unterschiedlich ist, die jeweils eine Basis, einen Kollektor und einen Emitter aufweisen, wobei die Eingangsstufe einen Eingangsanschluß (1) aufweist, der an den Emitter des ersten und des zweiten Transistors angeschlossen ist,
b) einer Ausgangsstufe mit einem dritten Transistor (5) des ersten Leitfähigkeitstyps und einem vierten Transistor (6) des zweiten Leitfähigkeitstyps, die jeweils eine Basis, einen Kollektor und einen Emitter aufweisen, und einem Anschluß (2), der an den Emitter des dritten und des vierten Transistors angeschlossen ist,
c) einer ersten Anschlußeinrichtung zum Anschluß der Basis des ersten Transistors (3) an die Basis und den Kollektor des dritten Transistors (5),
d) einer zweiten Anschlußeinrichtung zum Anschluß der Basis des zweiten Transistors (4) an die Basis und den Kollektor des vierten Transistors (6),
e) einer ersten Emitterfolger-Pegelschieberschaltung zum Anschluß des Kollektors des ersten Transistors (3) an den Kollektor des dritten Transistors (5), die einen fünften Transistor (8) des ersten Leitfähigkeitstyps und einen sechsten Transistor (7) des zweiten Leitfähigkeitstyps aufweist, und
f) einer zweiten Emitterfolger-Pegelschieberschaltung zum Anschluß des Kollektors des zweiten Transistors (4) an den Kollektor des vierten Transistors (6), die einen siebten Transistor (9) des ersten Leitfähigkeitstyps und einen achten Transistor (10) des zweiten Leitfähigkeitstyps aufweist,
g) wobei die Basis des sechsten (7) und des siebten (9) Transistors jeweils an den Kollektor des ersten (3) und des zweiten (4) Transistors angeschlossen ist, der Emitter des fünften (8) und des achten (10) Transistors jeweils an den Kollektor des dritten (5) und des vierten (6) Transistors angeschlossen ist, und die Basis des fünften (8) und des achten (10) Transistors jeweils an den Emitter des sechsten (7) und des siebenten (9) Transistors angeschlossen ist, so daß die Kollektor-Basis-Spannungen des ersten (3) und des zweiten (4) Transistors im wesentlichen auf Null gehalten werden.

2. Eine Pufferschaltung nach Anspruch 1, wobei die Pufferschaltung eine integrierte Halbleiterschaltung bildet.

3. Ein stromrückgekoppelter Operationsverstärker mit einer Eingangseinheit, die eine Pufferschaltung nach Anspruch 1 aufweist.

## Revendications

1. Circuit tampon comportant :
a) un étage d'entrée ayant un premier transistor (3) d'un premier type de conductivité et un second transistor (4) d'un second type de conductivité différent du premier type de conductivité, chacun ayant une base, un collecteur et un émetteur, et ledit étage d'entrée ayant une borne d'entrée (1) connectée aux émetteurs desdits premier et deuxième transistors ;
b) un étage de sortie ayant un troisième transistor (5) du premier type de conductivité et un deuxième transistor (6) du second type de conductivité, chacun ayant une base, un collecteur et un émetteur, et une borne (2) connectée aux émetteurs desdits troisième et quatrième transistors ;
c) un premier moyen de connexion destiné à connecter la base dudit premier transistor (3) à la base et au collecteur dudit troisième transistor (5),
d) un deuxième moyen de connexion destiné à connecter la base dudit deuxième transistor (4) à la base et au collecteur dudit quatrième transistor (6),
e) un premier circuit de décalage de niveau à montage émetteur-suiveur pour connecter le collecteur dudit premier transistor (3) au collecteur dudit troisième transistor (5), ayant un cinquième transistor (8) dudit premier type de conductivité et un sixième transistor (7) dudit second type de conductivité ; et
f) un second circuit de décalage de niveau à montage en émetteur-suiveur pour connecter le collecteur dudit deuxième transistor (4) au collecteur dudit quatrième transistor (6), ayant un septième transistor (9) dudit premier type de conductivité et un huitième transistor dudit second type de conductivité,
g) dans lequel lesdits sixième (7) et septième (9) transistor ont leur base connectée aux collecteurs desdits premier (3) et deuxième (4) transistors, respectivement, les émetteur desdits cinquième (8) et huitième (10) transistors sont connectés aux collecteurs desdits troisième (5) et quatrième (6) transistors, respectivement, et les bases desdits cinquième (8) et huitième (10) transistors sont connectées aux émetteurs desdits sixième (7) et septième (9) transistors, respectivement, de manière que les tensions collecteur-base desdits premier (3) et deuxième (4) transistors soient maintenues sensiblement à zéro.

2. Circuit tampon selon la revendication 1, dans lequel ledit circuit tampon consiste en un circuit intégré à semiconducteurs.

3. Amplificateur opérationnel du type à rétroaction de courant comportant une unité d'entrée pourvue d'un circuit tampon selon la revendication 1.
